# EUROPÄISCHE PATENTSCHRIFT

(11) **EP 4 115 158 B1**
(45) Veröffentlichungstag und Bekanntmachung des Hinweises auf die Patenterteilung: **09.04.2025**
(21) Anmeldenummer: 21705445.1
(22) Anmeldetag: 09.02.2021
(51) Int. Cl.: G01K 7/16

(54) **TEMPERATURSENSORVERBUND UND VERFAHREN ZUR HERSTELLUNG EINES TEMPERATURSENSORVERBUNDES**
TEMPERATURE-SENSOR ASSEMBLY AND METHOD FOR PRODUCING A TEMPERATURE-SENSOR ASSEMBLY
ENSEMBLE CAPTEUR DE TEMPÉRATURE ET SON PROCÉDÉ DE FABRICATION

(30) Priorität: 04.03.2020 DE 202020101197 U
(43) Veröffentlichungstag der Anmeldung: 11.01.2023
(73) Patentinhaber: Yageo Nexensos GmbH, 63801 Kleinostheim (DE)
(72) Erfinder: BLEIFUSS, Martin, 63801 Kleinostheim (DE); URFELS, Stephan, 63801 Kleinostheim (DE); WIENAND, Karlheinz, 63741 Aschaffenburg (DE)
(74) Vertreter: Meissner Bolte Partnerschaft mbB
(86) Internationale Anmeldenummer: PCT/EP2021/053078
(87) Internationale Veröffentlichungsnummer: WO 2021/175542

(56) Entgegenhaltungen:
- DE-A1- 102010 050 315
- DE-A1- 102014 110 553
- DE-C5- 102010 050 315
- US-A- 4 309 688

## Beschreibung

Die vorliegende Erfindung betrifft einen Temperatursensorverbund, umfassend mindestens einen Temperatursensor und mindestens eine Zuleitung. Des Weiteren betrifft die Erfindung ein Verfahren zur Herstellung eines Temperatursensorverbundes.

Es ist bekannt, Temperatursensoren mittels unterschiedlichster Verbindungsverfahren mit weiteren Komponenten zu verbinden. Da die Abmaße von entsprechenden Sensoren zunehmend kleiner werden, ist die Kontaktierung derartiger Temperatursensoren zunehmend mit entsprechenden Schwierigkeiten verbunden.

Eine oberseitige Kontaktierung von Kontaktflächen eines Temperatursensors erfolgt üblicherweise durch Drahtbonden, Löten oder Sintern. Da die Kontaktfläche der Temperatursensoren zunehmend kleiner werden, ist eine zuverlässige elektrische Kontaktierung dieser Kontaktflächen nur schwierig zu erreichen. Beispiele von solchen Temperatursensoren sind in DE 10 2010 050315 A1, DE 10 2014 110553 A1 und US 4 309 688 A zu finden.

Aufgabe der vorliegenden Erfindung ist es daher, einen verbesserten Temperatursensorverbund bereitzustellen, der einfach montiert und kontaktiert werden kann. Eine weitere Aufgabe der Erfindung besteht darin, ein Verfahren zur Herstellung eines derart verbesserten Temperatursensorverbundes anzugeben.

Diese Aufgabe wird erfindungsgemäß durch einen Temperatursensorverbund gemäß dem Gegenstand des Anspruches 1 gelöst. Hinsichtlich eines Verfahrens zur Herstellung eines Temperatursensorverbundes wird die Aufgabe gemäß Anspruch 14 gelöst.

Insbesondere wird die Aufgabe durch einen Temperatursensorverbund gelöst, der mindestens einen Temperatursensor und mindestens eine Zuleitung umfasst. Der Temperatursensor weist mindestens ein elektrisch isolierendes Substrat mit einer Oberseite und einer Unterseite auf. Auf der Oberseite ist zumindest abschnittsweise eine Temperatursensorstruktur mit mindestens einer Sensorkontaktfläche ausgebildet. Die Zuleitung des Temperatursensorverbundes weist mindestens eine Zuleitungskontaktfläche auf, wobei die Zuleitungsfläche mit der Sensorkontaktfläche zumindest abschnittsweise mittels einer ersten Sinterschicht verbunden ist.

Als Substrat kann ein derartiges Bauteil verstanden werden, das als elektrisch isolierendes Trägermaterial für die Temperatursensorstruktur dient. Die Oberflächen der Oberseite des Substrates und der Unterseite des Substrates können im Wesentlichen planar ausgestaltet sein.

Als Temperatursensorstruktur ist insbesondere eine derartige Struktur zu verstehen, die derart angepasst ist, einen Temperaturwert direkt oder indirekt zu erfassen. Beispielsweise kann die Temperatursensorstruktur ein auf das Substrat aufgedampftes Widerstandsnetzwerk sein.

Die mindestens eine Sensorkontaktfläche dient zur Kontaktierung der Temperatursensorstruktur. Die mindestens eine Sensorkontaktfläche kann aus leitfähigem Material ausgebildet sein. Es ist möglich, dass die Sensorkontaktfläche aus dem gleichen Material wie die Temperatursensorstruktur gebildet ist.

Beispielsweise kann die mindestens eine Sensorkontaktfläche an einem Ende der Temperatursensorstruktur ausgebildet sein. In einer bevorzugten Ausführungsform der Erfindung weist der Temperatursensor zwei Sensorkontaktflächen auf. Die Sensorkontaktflächen können dabei jeweils an einem Ende der Temperatursensorstruktur ausgebildet sein, um einen elektrischen Widerstand zwischen den beiden Sensorkontaktflächen zu messen.

Da der Temperatursensorverbund eine Zuleitung umfasst, die bereits mit der mindestens einen Sensorkontaktfläche verbunden ist, kann der Temperatursensorverbund in dieser Form als Zwischenprodukt einfach gehandhabt werden. Des Weiteren ist die Kontaktierung des Temperatursensorverbundes beispielsweise auf einer Leiterplatte relativ einfach, da die kleine Sensorkontaktfläche bereits kontaktiert ist.

Hierzu weist die Zuleitung mindestens eine Zuleitungskontaktfläche auf, wobei die Zuleitungskontaktfläche mit der Sensorkontaktfläche zumindest abschnittsweise mittels einer ersten Sinterschicht verbunden ist.

Als Sinterschicht ist insbesondere eine derartige Schicht zu verstehen, die bereits eine vollständige Verbindung zwischen der Zuleitungskontaktfläche und der Sensorkontaktfläche herstellt. Diese vollständige Verbindung betrifft sowohl eine mechanische Verbindung als auch eine elektrische Verbindung bzw. Kontaktierung. Mit anderen Worten handelt es sich bei der Sinterschicht vorzugsweise um eine bereits gesinterte Schicht.

Die erste Sinterschicht ist vorzugsweise aus einer ersten vorapplizierten Sinterpastenschicht, die auf der Zuleitungskontaktfläche und/oder der Sensorkontaktfläche aufgetragen ist, gebildet. Bei einer vorapplizierten Sinterpastenschicht handelt es sich um eine derartige Schicht, die noch reaktiv ist. Mit anderen Worten weist eine vorapplizierte Sinterpastenschicht zumindest eine Rest-Reaktivität auf. Demnach wird aus einer vorapplizierten Sinterpastenschicht durch Druck und/oder Temperaturaufschlag eine Sinterschicht gebildet.

Im Folgenden wird vorzugsweise zwischen den Begrifflichkeiten Sinterschicht und vorapplizierter Sinterpastenschicht unterschieden. Bei einer vorapplizierten Sinterpastenschicht handelt es sich um eine zumindest noch nicht vollständig hergestellte Sinterschicht. Eine vorapplizierte Sinterpastenschicht weist zumindest eine Rest-Reaktivität für einen später folgenden Sinterprozess und/oder Verbindungsprozess auf.

Die Zuleitung des Temperatursensorverbundes ist vorzugsweise flexibel ausgestaltet. Eine derart flexible Ausgestaltung weist den Vorteil auf, dass die Verbindung des Temperatursensors mit einem weiteren Bauteil einfach durchgeführt werden kann, da die Zuleitung beispielsweise derart gebogen werden kann, dass eine Verbindung einer weiteren Zuleitungskontaktfläche mit einem weiteren Bauteil unabhängig von der tatsächlichen Positionierung des weiteren Bauteiles möglich ist.

In einer Ausführungsform der Erfindung ist die Zuleitung aus einem Metallband und/oder einem Metalldraht gebildet. Das Metallband und/oder der Metalldraht weist vorzugsweise mindestens ein abgeflachtes Ende auf. Das abgeflachte Ende bildet vorzugsweise die Zuleitungskontaktfläche der Zuleitung.

Des Weiteren kann es sich bei der Zuleitung um ein metallbeschichtetes Polymersubstrat und/oder ein Metallblech handeln. Das Metallblech ist insbesondere gestanzt oder gelasert oder geätzt ausgebildet.

In einer weiteren Ausführungsform der Erfindung ist es möglich, dass der Temperatursensorverbund einen Zuleitungsträger aufweist. Auf dem Zuleitungsträger kann mindestens eine Zuleitung aufgebracht sein. Vorzugsweise sind auf dem Zuleitungsträger mehrere Zuleitungen ausgebildet. Insbesondere bei einer derartigen Ausführung der Erfindung mit einem Zuleitungsträger, kann die mindestens eine Zuleitung aus einer Paste, insbesondere einer Silberpaste, gebildet sein. Der Zuleitungsträger kann beispielsweise aus einer Folie, insbesondere einer Polyimidfolie, gebildet sein. Mit Hilfe eines Zuleitungsträgers ist es möglich, mindestens eine Zuleitung bereits in einem vorbereitenden Montageschritt korrekt zu positionieren.

In einer weiteren Ausführungsform der Erfindung ist die Temperatursensorstruktur als ein Widerstandselement ausgebildet. Wie bereits beschrieben, kann mithilfe einer derartigen Temperatursensorstruktur bzw. Widerstandsstruktur ein elektrischer Widerstand zwischen vorzugsweise zwei ausgebildeten Sensorkontaktflächen gemessen werden.

In einer besonders bevorzugten Ausführungsform der Erfindung weisen die Temperatursensorstruktur und/oder die mindestens eine Sensorkontaktfläche Platinmaterial auf. Es ist möglich, dass die Temperatursensorstruktur oder die mindestens eine Sensorkontaktfläche aus Platinmaterial gebildet ist. Besonders bevorzugt ist es, dass sowohl die Temperatursensorstruktur als auch die mindestens eine Sensorkontaktfläche aus Platin gebildet ist. Es ist möglich, dass anstelle eines Platinmaterials eine Platinlegierung verwendet wird.

Vorzugsweise sind bei Ausbildung von mindestens zwei Sensorkontaktflächen beide Kontaktflächen auf der Oberseite des Substrates ausgebildet. Dies dient einer besseren Kontaktierbarkeit der Sensorkontaktflächen. Alternativ ist es möglich, dass eine der Kontaktflächen auch auf einer anderen Seite des Substrates ausgebildet sein kann.

In einer Ausführungsform der Erfindung weist der Temperatursensorverbund mindestens eine Passivierungsschicht auf, die zumindest abschnittsweise auf der Temperatursensorstruktur und/oder, vorzugsweise vollflächig, auf der Oberseite des Substrates ausgebildet ist. Vorteilhaft kann durch Ausbilden einer Passivierungsschicht ein stark verringertes Reaktionsvermögen an der Oberfläche der Temperatursensorstruktur erreicht werden. Mit anderen Worten wird die Oberfläche der Temperatursensorstruktur durch die Passivierungsschicht, insbesondere vor Korrosion, geschützt,. Somit kann aufgrund des verringerten Reaktionsvermögens an der Oberfläche der Temperatursensorstruktur, das Temperatursensorelement mit einer hohen Genauigkeit über lange Zeiträume hinweg betrieben werden.

Beispielsweise kann die Passivierungsschicht zumindest ein Polyimid-Material oder ein Glasmaterial und/oder ein Keramikmaterial und/oder ein Glaskeramikmaterial aufweisen. In weiteren Ausführungsformen der Erfindung besteht die Passivierungsschicht aus einem Polyimid-Material oder einem Glasmaterial und/oder einem Keramikmaterial und/oder einem Glaskeramikmaterial.

Das Substrat weist vorzugsweise ein keramisches Isolationsmaterial, insbesondere Aluminiumoxid und/oder Aluminiumnitrid und/oder Siliziumnitrid auf. Des Weiteren ist es möglich, dass das Substrat ein Glas-Sandwichmaterial aufweist.

In einer weiteren Ausführungsform der Erfindung ist es möglich, dass das Substrat ein Leiterplattenmaterial aufweist.

Vorteilhaft bieten keramische Isolationsmaterialien eine Kombination aus guten mechanischen, chemischen, thermischen und elektrischen Eigenschaften.

Auf der Unterseite des Substrates kann eine Metallisierungsschicht ausgebildet sein. Die Metallisierungsschicht weist vorzugsweise ein Silbermaterial und/oder ein Goldmaterial und/oder eine Metalllegierung auf. Es hat sich gezeigt, dass diese Metalle besonders gute Metallisierungsschichten im Zusammenhang mit Temperatursensoren bilden.

Auf der Metallisierungsschicht oder auf der Unterseite des Substrats kann eine zweite Sinterschicht und/oder eine zweite Sinterpastenschicht ausgebildet sein. Eine zweite Sinterschicht liegt dann vor, sofern eine vorapplizierte Sinterpastenschicht bereits gezielt einer Wärme- und/oder Druckbeaufschlagung ausgesetzt wurde. Im Zusammenhang mit der zweiten Sinterschicht und/oder zweiten Sinterpastenschicht wird auf die bereits vorangegangenen Erläuterungen im Zusammenhang mit der ersten Sinterschicht und/oder ersten Sinterpastenschicht verwiesen.

Die zweite Sinterschicht ist vorzugsweise aus einer vorapplizierten Sinterpastenschicht gebildet.

Die zweite Sinterschicht und/oder die zweite Sinterpastenschicht kann wiederum Teil eines Zwischenproduktes sein, wonach ein Temperatursensorverbund zunächst in diesem Umfang hergestellt wird, zu einem Kunden transportiert wird und anschließend beim Kunden entsprechend verbaut wird.

Die zweite Sinterschicht und/oder die zweite Sinterpastenschicht dient insbesondere zur Anbringung und Kontaktierung des Temperatursensors auf einer Leiterplatte.

Es ist darauf hinzuweisen, dass im Folgenden als erste Sinterschicht bzw. erste vorapplizierte Sinterpastenschicht immer die Sinterschicht bzw. vorapplizierte Sinterpastenschicht zu verstehen ist, die eine Verbindung zwischen einer Zuleitung und dem Temperatursensor herstellt.

Als zweite Sinterschicht bzw. als zweite vorapplizierte Sinterpastenschicht ist die Sinterschicht bzw. vorapplizierte Sinterpastenschicht zu verstehen, die eine Verbindung zwischen dem Sensor und einem weiteren Bauteil, insbesondere einem Bauteilträger, herstellt.

Die Begrifflichkeiten "erste" und "zweite" treffen keine Aussage darüber, welche der Sinterschichten/vorapplizierten Sinterpastenschichten als erstes oder als zweites aufgetragen werden.

Die erste Sinterschicht kann auch als obere Sinterschicht bezeichnet werden. Die erste vorapplizierte Sinterpastenschicht kann auch als obere vorapplizierte Sinterpastenschicht bezeichnet werden. Die zweite Sinterschicht kann auch als untere Sinterschicht bezeichnet werden. Die zweite vorapplizierte Sinterpastenschicht kann auch als untere vorapplizierte Sinterpastenschicht bezeichnet werden.

Die erste Sinterschicht und/oder die zweite Sinterschicht und/oder die erste vorapplizierte Sinterpastenschicht und/oder die zweite vorapplizierte Sinterpastenschicht weist vorzugsweise Metallpartikel, insbesondere Edelmetallpartikel, besonders bevorzugt Silberpartikel und/oder Goldpartikel und/oder Platinpartikel auf.

Die zur Herstellung der ersten und/oder zweiten vorapplizierten Sinterpastenschicht notwendige Sinterpaste kann mit anderen Worten Metallpartikel, insbesondere Edelmetallpartikel, besonders bevorzugt Silberpartikel und/oder Goldpartikel und/oder Platinpartikel aufweisen.

Die Sinterpaste kann beispielsweise mittels Schablonendruck und/oder Siebdruck und/oder Jet-Printing und/oder Dispensen und/oder Transferdruck aufgebracht werden.

Das Aufbringen der Sinterpaste auf die Zuleitungskontaktfläche und/oder die Sensorkontaktfläche und/oder die Metallisierungsschicht und/oder auf die Unterseite des Substrats kann mit einer vorbestimmten Struktur erfolgen. Insbesondere kann die Struktur passgenau zur Struktur des Substrates und/oder der Temperatursensorstruktur aufgebracht werden. Mittels der genannten Techniken kann die Sinterpaste mit einer derartigen Form vorappliziert werden.

Aufgrund des erfindungsgemäßen Temperatursensorverbundes kann ein derartiger Temperatursensorverbund zur Verfügung gestellt werden, der zum einen einfach zu transportieren ist und zum anderen einfach auf weiteren Bauteilen aufgebracht und/oder mit weiteren Bauteilen verbunden werden kann. Dies betrifft sowohl das mechanische als auch das elektrische Verbinden.

Die mindestens eine Sensorkontaktfläche ist mit der Temperatursensorstruktur elektrisch verbunden. Die Zuleitungskontaktfläche der Zuleitung ist wiederum mit der Zuleitung elektrisch verbunden.

Unter dem Begriff Sintern wird allgemein ein Verfahren zur Herstellung oder Veränderung von Werkstoffen beschrieben. Dabei werden feinkörnige keramische oder metallische Stoffe, oftmals unter erhöhtem Druck, erhitzt, wobei die Temperaturen unterhalb der Schmelztemperatur der Hauptkomponenten bleiben. Demnach bleibt die Gestalt bzw. die Form des Werkstückes erhalten.

Vorzugsweise wird die Sinterpaste vor dem Sintervorgang getrocknet. Während des Sintervorganges werden die zu verbindenden Elemente bzw. Abschnitte positioniert und dann mit oder ohne Druck und ggf. bei erhöhter Temperatur miteinander verbunden.

Herstellungstechnisch ist es von Vorteil, die Sinterpaste auf mindestens eine der zu verbindenden Fläche vor der Montage aufzubringen. Die Sinterpaste wird auf der Fläche aufgetragen und vorgetrocknet. Dieser Schritt des Auftragens und Vortrocknens wird auch als Vorapplizieren bezeichnet. Dies hat den Vorteil, dass zunächst kein Druck- und Trocknungsprozess der Sinterpaste hinsichtlich des Verbindens der Flächen erfolgen muss.

Die spätere Handhabung des Bauteiles bei der Montage vereinfacht sich, da eine vorapplizierte Sinterpastenschicht nicht mehr klebt.

Nach Positionierung des Temperatursensorverbundes auf dem tatsächlich zu verbindenden Bauteil, insbesondere auf der zu verbindenden Leiterplatte, kann mittels eines temperierbaren Stempels der auf das zu verbindende Bauteil drückt, die endgültige Sinterverbindung, d. h. die tatsächliche Sinterschicht, hergestellt werden.

Alternativ ist es möglich, dass auf der Unterseite des Substrates oder auf der Metallisierungsschicht anstelle einer Sinterschicht oder vorapplizierten Sinterpastenschicht eine andere Verbindungsschicht aufgetragen ist, um das Substrat bzw. den Temperatursensor mit einem weiteren Bauteil, insbesondere einer Leiterplatte, zu verbinden. Beispielsweise ist es möglich, dass der Temperatursensor mittels einer Klebschicht mit einem weiteren Bauteil, insbesondere einer Leiterplatte, verbunden ist. Als Klebschicht kommen beispielsweise Schichten in Frage, die ein reaktives Klebemittel aufweisen. Bei dem reaktiven Klebemittel kann es sich beispielsweise um Epoxy-Kleber und/oder Cyanacrylat-Kleber handeln.

Besonders bevorzugt ist die Zuleitung aus einem flachen Material, insbesondere einem flachen Metallband, gebildet. Das Ausbilden einer flachen Zuleitung weist den Vorteil auf, dass derartige Zuleitungen bereits bei der Fertigung von Power Electronic Boards (PEBs) verwendet werden. Flache Zuleitungen weisen eine große Stromdichtentragfähigkeit bei gleichzeitig geringer Erzeugung von Induktionsfeldern auf. Es ist demnach möglich, bei der Integration eines Temperatursensors auf einem Power Electronic Board die gleichen Zuleitungen zu verwenden, wie diese bei der Verbindung von Leistungshalbleiterelementen verwendet werden. Dies erleichtert den Fertigungsprozess erheblich.

Die weitere bevorzugte Ausführungsform der Erfindung umfasst eine Zuleitung aus einem metallbeschichteten Polymersubstrat. Dabei kann es sich um eine metallisierte Polyimid-Folie handeln. Derartig metallisierte Polyimid-Folien sind besonders vorteilhaft, da diese insbesondere im Bereich von Low-Power-Elektronik eingesetzt und zur Kontaktierung von Temperatursensoren besonders geeignet sind. Metallisierte Polyimid-Folien sind besonders kostengünstig, direkt von einer Vorratsrolle applizierbar und äußerst flexibel.

Die Ausbildung einer flachen Zuleitung weist zudem den Vorteil auf, dass auf der Oberseite des Temperatursensorverbundes eine flache Konstruktion ausgebildet werden kann. Aufgrund der Ausbildung von flachen Zuleitungen und somit einer flachen Zuleitungskontaktfläche befinden sich diese Zuleitungen und die Oberflächen des Temperatursensors annähernd auf einer Ebene. Aufgrund dessen wird der thermische Kontakt zwischen dem Temperatursensor und einem an die Oberfläche gepressten Kühlkörper erhöht. Auf diese Weise lassen sich doppelseitige Kühlungen eines Power Electronic Boards realisieren. Mit anderen Worten kann das Substrat sowohl an seiner Oberseite als auch an seiner Unterseite mit einem Kühlkörper verbunden sein.

Ein weiterer Aspekt der Erfindung betrifft ein Verfahren zur Herstellung eines erfindungsgemäßen Temperatursensorverbunds.

Das erfindungsgemäße Verfahren beruht dem Grunde nach auf folgenden Verfahrensschritten:
- Bereitstellen eines Temperatursensor, der mindestens ein elektrisch isolierendes Substrat mit einer Oberseite und einer Unterseite aufweist, wobei auf der Oberseite zumindest abschnittsweise eine Temperatursensorstruktur mit mindestens einer Sensorkontaktfläche ausgebildet ist,
- Bereitstellen einer Zuleitung, die mindestens eine Zuleitungskontaktfläche aufweist,
- Auftragen einer Sinterpaste auf der Sensorkontaktfläche und/oder der Zuleitungskontaktfläche,
- Bilden mindestens einer ersten vorapplizierten Sinterpastenschicht,
- Verbinden der Zuleitung mit dem Temperatursensor mittels Bildung einer Sinterschicht aufgrund eines Sinterprozesses.

Der erfindungsgemäße Temperatursensorverbund kann mithilfe folgender beispielhafter Verfahren hergestellt und/oder weiterverwendet werden.

### Erste Ausführungsform eines Herstellungsverfahrens:

In einem ersten Verfahrensschritt wird Sinterpaste auf mindestens einer Sensorkontaktfläche aufgetragen. Es wird eine erste vorapplizierte Sinterpastenschicht gebildet. Auf der Unterseite des Substrates oder auf einer Metallisierungsschicht des Substrates wird zumindest abschnittsweise eine Sinterpaste aufgetragen. Es wird eine zweite vorapplizierte Sinterpastenschicht gebildet.

Anschließend wird der Temperatursensor mittels Drucksintern mit der zweiten vorapplizierten Sinterpastenschicht mit einem weiteren Bauteil sowie die Sensorkontaktfläche mit einer Zuleitungskontaktfläche einer Zuleitung verbunden. Der Drucksinterprozess hinsichtlich der zu verbindenden Zuleitung sowie des zu verbindenden weiteren Bauteiles kann gleichzeitig oder nacheinander erfolgen.

Sofern gemäß einer ersten Variante zunächst die Verbindung des Temperatursensors mit einem weiteren Bauteil erfolgt, ist bei dem ersten Drucksinterprozess darauf zu achten, dass ein temperierbarer Stempel nicht auf die erste vorapplizierte Sinterpastenschicht wirkt. Anschließend wird die mindestens eine Zuleitung mit der Zuleitungskontaktfläche in Relation zu der Sensorkontaktfläche des Temperatursensors positioniert und durch einen Drucksinterprozess verbunden.

### Zweite Ausführungsform eines Herstellungsverfahrens:

In einem ersten Schritt wird auf der Unterseite des Substrates oder auf der Metallisierungsschicht eine Sinterpastenschicht aufgetragen. Es wird zunächst die zweite vorapplizierte Sinterpastenschicht gebildet. Anschließend erfolgt das Verbinden des Temperatursensors mittels der vorapplizierten Sinterpastenschicht auf einem weiteren Bauteil.

Anschließend wird auf die mindestens eine Sensorkontaktfläche und/oder auf die mindestens eine Zuleitungskontaktfläche zumindest abschnittsweise eine Sinterpaste aufgebracht. Es wird die erste vorapplizierte Sinterpastenschicht gebildet.

Anschließend wird die Zuleitungskontaktfläche in Relation zur Sensorkontaktfläche positioniert. Es folgt ein Sintervorgang, bei dem die Zuleitungskontaktfläche mit der Sensorkontaktfläche mittels der ersten vorapplizierten Sinterpastenschicht verbunden wird. Vorzugsweise wird diesbezüglich ein temperierbarer Stempel verwendet, der die Zuleitung, insbesondere die Zuleitungskontaktfläche auf den Temperatursensor, insbesondere auf die Sensorkontaktfläche, presst.

### Dritte Ausführungsform eines Herstellungsverfahrens:

In einem ersten Schritt wird eine erste vorapplizierte Sinterpastenschicht ausgebildet.

Hierzu wird eine Sinterpaste auf mindestens eine Sensorkontaktfläche und/oder auf mindestens eine Zuleitungskontaktfläche einer Zuleitung aufgebracht.

Der Temperatursensor wird anschließend mit einem weiteren Bauteil verbunden. Hierzu erfolgt die Verbindung des Temperatursensors auf der Unterseite des Substrates oder auf der Metallisierungsschicht mit dem mindestens einen weiteren Bauteil. Es ist möglich, dass diese Verbindung mittels einer Klebschicht und/oder Lötschicht und/oder Sinterschicht gebildet wird.

Anschließend wird die Zuleitung mit dem Temperatursensor verbunden. Hierzu wird zwischen der mindestens einen Zuleitungskontaktfläche und der mindestens einen Sensorkontaktfläche die erste Sinterschicht aufgrund eines Sinterprozesses gebildet.

### Vierte Ausführungsform eines Herstellungsverfahrens:

In einem ersten Schritt wird auf die mindestens eine Zuleitungskontaktfläche mindestens einer Zuleitung eine erste Sinterpaste aufgebracht und die erste vorapplizierte Sinterpastenschicht gebildet.

Anschließend oder vorhergehend oder gleichzeitig, wird der Temperatursensor mit einem weiteren Bauteil, insbesondere einem Bauteilträger verbunden. Hierzu wird die Unterseite des Substrates oder die Metallisierungsschicht des Temperatursensors mit dem weiteren Bauteil, insbesondere dem Bauteilträger verbunden. Vorzugsweise erfolgt diese Verbindung aufgrund Ausbildens einer zweiten Sinterschicht zwischen dem Temperatursensor und dem weiteren Bauteil, insbesondere dem Bauteilträger.

Weitere Merkmale und Vorteile der Erfindung ergeben sich aus der nachfolgenden Beschreibung.

Nachfolgend wird die Erfindung anhand von Ausführungsbeispielen unter Bezug auf die beigefügten Zeichnungen näher erläutert.

In diesen zeigen:
- Fig. 1: eine erste Ausführungsform eines erfindungsgemäßen Temperatursensorverbundes;
- Fig. 2: eine zweite Ausführungsform eines erfindungsgemäßen Temperatursensorverbundes; und
- Fig. 3: eine dritte Ausführungsform eines erfindungsgemäßen Temperatursensorverbundes.

Im Folgenden werden für gleiche und gleich wirkende Bauteile die gleichen Bezugsziffern verwendet.

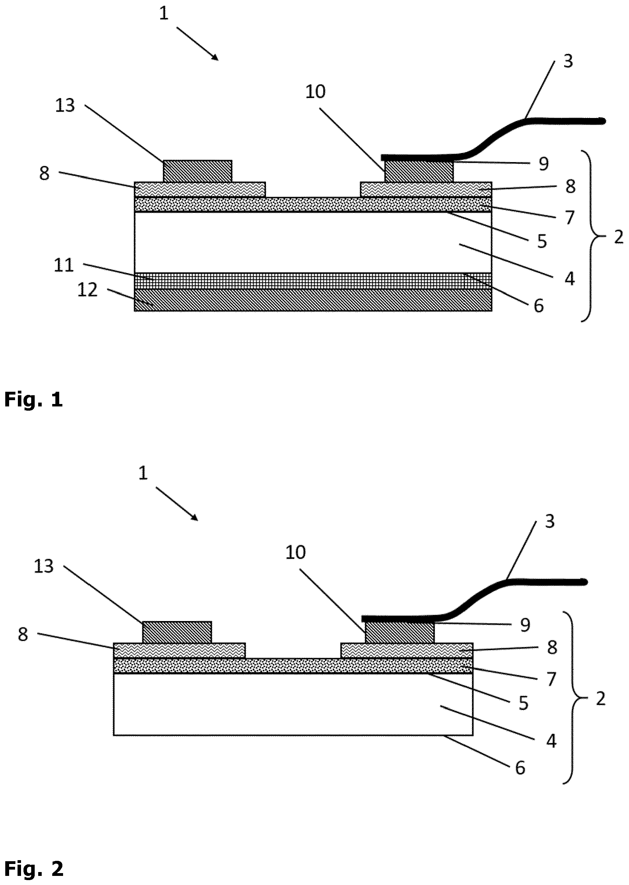

Fig. 1 zeigt eine erste Ausführungsform eines erfindungsgemäßen Temperatursensorverbundes 1. Dieser umfasst im Wesentlichen einen Temperatursensor 2 und mindestens eine Zuleitung 3. Der Temperatursensor 2 weist ein elektrisch isolierendes Substrat 4 mit einer Oberseite 5 und einer Unterseite 6 auf. Auf der Oberseite 5 des Substrates 4 ist zumindest abschnittsweise eine Temperatursensorstruktur 7 ausgebildet.

Ebenfalls zu erkennen sind zwei Sensorkontaktflächen 8. Vorzugsweise sind die Temperatursensorstruktur 7 sowie die Sensorkontaktflächen 8 aus dem gleichen Material gebildet. Besonders bevorzugt sind diese aus einem Platinmaterial gebildet.

Die Zuleitung 3 ist flexibel ausgebildet. Im dargestellten Beispiel ist die Zuleitung 3 aus einem flachen Metallband gebildet. Es ist möglich, dass die Zuleitung 3 aus einem metallbeschichteten Polymersubstrat gebildet ist. Das vordere Ende der Zuleitung 3 umfasst eine Zuleitungskontaktfläche 9. Die Zuleitungskontaktfläche 9 ist vorzugsweise der Abschnitt der Zuleitung 3, der mit der Sensorkontaktfläche 8 verbunden werden soll. Eine der Sensorkontaktflächen 8 ist mit der dargestellten Zuleitungskontaktfläche 9 der Zuleitung 3 mittels einer ersten Sinterschicht 10 verbunden.

In Fig. 1 ist lediglich eine Zuleitung 3 dargestellt. Die weitere Sensorkontaktfläche 8 wird vorzugsweise in einem späteren Verfahrensschritt (nicht dargestellt) ebenfalls mit einer Zuleitung 3 verbunden. Diesbezüglich ist bereits eine erste vorapplizierte Sinterpastenschicht 13 ausgebildet. Der Unterschied zwischen der ersten Sinterschicht 10 und der ersten vorapplizierten Sinterpastenschicht 13 besteht darin, dass die erste vorapplizierte Sinterpastenschicht 13 eine Rest-Reaktivität aufweist, um eine Verbindung mit der Zuleitung 3, insbesondere der Zuleitungskontaktfläche 9 zu ermöglichen. Sofern der Sinterprozess abgeschlossen ist, wird eine erste Sinterschicht 10 gebildet, wie diese in Fig. 1 bereits dargestellt ist.

Der Temperatursensor 2 weist im dargestellten Beispiel auf der Unterseite 6 des Substrates 4 eine Metallisierungsschicht auf. Die Metallisierungsschicht 11 weist vorzugsweise ein Silbermaterial und/oder ein Goldmaterial und/oder eine Metalllegierung auf. Auf der Metallisierungsschicht 11 ist wiederum eine zweite vorapplizierte Sinterpastenschicht 12 aufgebracht. Diese zweite vorapplizierte Sinterpastenschicht 12 dient zur Verbindung des Temperatursensorverbundes 1 mit einem weiteren Bauteil, insbesondere mit einem Bauteilträger.

Der dargestellte Temperatursensorverbund 1 kann in dieser Form als Zwischenprodukt transportiert werden. Hierzu könnte eine weitere Zuleitung 3 auf der ersten vorapplizierten Sinterpastenschicht 13 aufgebracht sein.

In dieser Form kann das Zwischenprodukt zu einem Kunden transportiert werden. Da es sich bei der Schicht 12 um eine vorapplizierte Sinterpastenschicht handelt, die eine Rest-Reaktivität aufweist, kann der Temperatursensorverbund 1 einfach mit einem weiteren Bauteil (nicht dargestellt), insbesondere mit einem Bauteilträger, verbunden werden.

Des Weiteren ist es möglich, dass die Zuleitung 3 auf dem zweiten Ende (nicht dargestellt) ebenfalls eine Zuleitungskontaktfläche aufweist. Diese weitere Zuleitungskontaktfläche kann bereits eine vorapplizierte Sinterpastenschicht aufweisen. Des Weiteren ist es möglich, dass das weitere Ende der Zuleitung mithilfe einer anderen Verbindungstechnik mit weiteren Bauteilen verbunden wird.

Die Ausführungsform gemäß Fig. 2 weist im Wesentlichen die gleichen Elemente bzw. Schichten auf, wie diese bereits im Zusammenhang mit der Ausführungsform gemäß Fig. 1 dargelegt wurden.

Es ist zu erkennen, dass auf der Unterseite 6 des Substrates 4 jedoch keine Metallisierungsschicht sowie keine vorapplizierte Sinterpastenschicht aufgebracht ist.

Auch der in Fig. 2 dargestellte Temperatursensorverbund 1 kann als Zwischenprodukt zu einem Kunden transportiert werden. Die Verbindung des Substrates 4 mit einem weiteren Bauteil, insbesondere mit einem Bauteilträger, kann beispielsweise mittels einer Klebschicht (nicht dargestellt) erfolgen. Des Weiteren ist es möglich, dass eine vorapplizierte Sinterpastenschicht auf dem zu verbindenden Bauteil, insbesondere auf dem Bauteilträger, ausgebildet wird, so dass die Unterseite 6 des Substrates 4 auf diese vorapplizierte Sinterpastenschicht aufgesetzt und anschließend mit dieser verbunden werden kann.

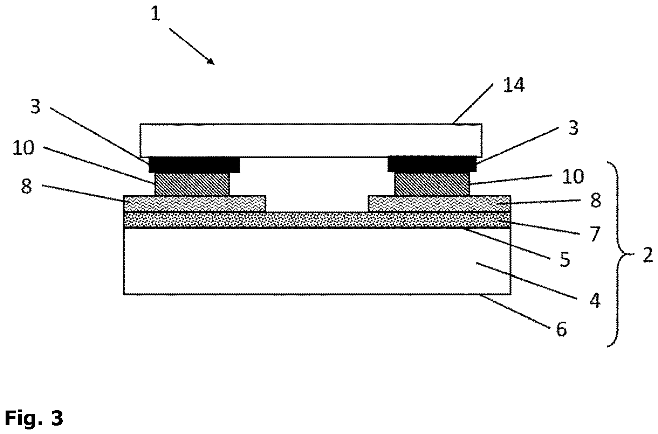

In Figur 3 wird eine weitere Ausgestaltungsform des Temperatursensorverbunds 1 im Querschnitt dargestellt.

Auf einem Zuleitungsträger 14 sind die Zuleitungen 3 aufgebracht. Der Zuleitungsträger 14 kann z.B. aus einer Polyimidfolie bestehen und die Zuleitungen 3 z.B. aus Streifen einer aufgedruckten Ag-Paste. Die Zuleitungen 3 sind mit den Sensorkontaktflächen 8 über eine erste Sinterschicht 10 miteinander verbunden.

Die erste Sinterschicht 10 wird vor dem Zusammenfügen auf den Zuleitungen 3 und/oder den Sensorkontaktflächen 8 vorappliziert.

### Bezugszeichenliste

- 1: Temperatursensorverbund
- 2: Temperatursensor
- 3: Zuleitung
- 4: Substrat
- 5: Oberseite
- 6: Unterseite
- 7: Temperatursensorstruktur
- 8: Sensorkontaktfläche
- 9: Zuleitungskontaktfläche
- 10: erste Sinterschicht
- 11: Metallisierungsschicht
- 12: zweite vorapplizierte Sinterpastenschicht
- 13: erste vorapplizierte Sinterpastenschicht
- 14: Zuleitungsträger

## Patentansprüche

1. Temperatursensorverbund (1),
umfassend mindestens einen Temperatursensor (2) und mindestens eine Zuleitung (3), wobei
der Temperatursensor (2) mindestens ein elektrisch isolierendes Substrat (4) mit einer Oberseite (5) und einer Unterseite (6) aufweist, wobei auf der Oberseite (5) zumindest abschnittsweise eine Temperatursensorstruktur (7) mit mindestens einer Sensorkontaktfläche (8) ausgebildet ist, wobei
die Zuleitung (3) mindestens eine Zuleitungskontaktfläche (9) aufweist,
wobei die Zuleitungskontaktfläche (9) mit der Sensorkontaktfläche (8) zumindest abschnittsweise mittels einer ersten Sinterschicht (10) verbunden ist,
**dadurch gekennzeichnet, dass**
die erste Sinterschicht (10) aus einer ersten vorapplizierten Sinterpastenschicht (13), die auf der Zuleitungskontaktfläche (9) und/oder der Sensorkontaktfläche (8) aufgetragen ist, gebildet ist.

2. Temperatursensorverbund (1) nach Anspruch 1,**dadurch gekennzeichnet, dass**
die Zuleitung (3) flexibel ausgebildet ist.

3. Temperatursensorverbund (1) nach einem der Ansprüche 1 oder 2,
**dadurch gekennzeichnet, dass**
die Zuleitung (3) aus einem Metallband und/oder einem Metalldraht mit mindestens einem abgeflachten Ende und/oder einem metallbeschichteten Polymersubstrat und/oder einem, insbesondere gestanzten oder gelaserten oder geätzten, Metallblech gebildet ist.

4. Temperatursensorverbund (1) nach einem der vorangegangenen Ansprüche,
**dadurch gekennzeichnet, dass**
die Temperatursensorstruktur (7) als ein Widerstandselement ausgebildet ist.

5. Temperatursensorverbund (1) nach einem der vorangegangenen Ansprüche,
**dadurch gekennzeichnet, dass**
die Temperatursensorstruktur (7) und/oder die Sensorkontaktfläche (8) Platinmaterial aufweist.

6. Temperatursensorverbund (1) nach einem der vorangegangenen Ansprüche, **gekennzeichnet durch**
mindestens eine Passivierungsschicht, die zumindest abschnittsweise auf der Temperatursensorstruktur (7) und/oder, vorzugsweise vollflächig, auf der Oberseite (5) des Substrats (4) ausgebildet ist.

7. Temperatursensorverbund (1) nach Anspruch 6,
**dadurch gekennzeichnet, dass**
die Passivierungsschicht ein Polyimidmaterial und/oder ein Glasmaterial und/oder ein Keramikmaterial und/oder ein Glaskeramikmaterial aufweist.

8. Temperatursensorverbund (1) nach einem der vorangegangenen Ansprüche,
**dadurch gekennzeichnet, dass**
das Substrat (4) ein keramisches Isolationsmaterial, insbesondere Aluminiumoxid und/oder Aluminiumnitrid und/oder Siliciumnitrid, und/oder ein Glassandwichmaterial aufweist.

9. Temperatursensorverbund (1) nach einem der vorangegangenen Ansprüche,
**dadurch gekennzeichnet, dass**
auf der Unterseite (6) des Substrats (4) eine Metallisierungsschicht (11) ausgebildet ist, die vorzugsweise ein Silbermaterial und/oder ein Goldmaterial und/oder eine Metalllegierung aufweist.

10. Temperatursensorverbund (1) nach einem der vorangegangenen Ansprüche, insbesondere nach Anspruch 9,
**dadurch gekennzeichnet, dass**
auf der Unterseite (6) des Substrats (4) oder auf der Metallisierungsschicht (11) eine zweite Sinterschicht und/oder eine zweite Sinterpastenschicht (12) ausgebildet ist.

11. Temperatursensorverbund (1) nach Anspruch 10,
**dadurch gekennzeichnet, dass**
die zweite Sinterschicht aus einer zweiten vorapplizierten Sinterpastenschicht (12) gebildet ist.

12. Temperatursensorverbund (1) nach einem der vorangegangenen Ansprüche,
**dadurch gekennzeichnet, dass**
die erste Sinterschicht (10) und/oder die zweite Sinterschicht und/oder die erste vorapplizierte Sinterpastenschicht (13) und/oder die zweite vorapplizierte Sinterpastenschicht (12) Metallpartikel, insbesondere Edelmetallpartikel, besonders bevorzugt Silberpartikel und/oder Goldpartikel und/oder Platinpartikel, aufweist/aufweisen.

13. Verfahren zur Herstellung eines Temperatursensorverbundes (1) nach einem der Ansprüche 1 bis 12, umfassend mindestens einen Temperatursensor (2) und mindestens eine Zuleitung (3)
**gekennzeichnet durch** die Verfahrensschritte:
- Bereitstellen eines Temperatursensor (2), der mindestens ein elektrisch isolierendes Substrat (4) mit einer Oberseite (5) und einer Unterseite (6) aufweist, wobei auf der Oberseite (5) zumindest abschnittsweise eine Temperatursensorstruktur (7) mit mindestens einer Sensorkontaktfläche (8) ausgebildet ist,
- Bereitstellen einer Zuleitung (3), die mindestens eine Zuleitungskontaktfläche (9) aufweist,
- Auftragen einer Sinterpaste auf der Sensorkontaktfläche (8) und/oder der Zuleitungskontaktfläche (9),
- Bilden mindestens einer ersten vorapplizierten Sinterpastenschicht (13),
- Verbinden der Zuleitung (3) mit dem Temperatursensor (2) mittels Bildung einer Sinterschicht (10) aufgrund eines Sinterprozesses.

14. Verfahren nach Anspruch 13,
**gekennzeichnet durch**
- zumindest abschnittsweises Auftragen einer Sinterpaste auf die Unterseite (6) des Substrates (4) oder auf eine Metallisierungsschicht (11) des Substrates (4),
- Bilden einer zweiten vorapplizierten Sinterpastenschicht (12),
- Verbinden des Temperatursensors (2) mittels Drucksintern mit der zweiten vorapplizierten Sinterpastenschicht (12) mit einem weiteren Bauteil.

## Claims

1. A temperature sensor assembly (1),
comprising at least one temperature sensor (2) and at least one feed line (3),
wherein
the temperature sensor (2) has at least one electrically insulating substrate (4) with an upper side (5) and a lower side (6), wherein a temperature sensor structure (7) with at least one sensor contact surface (8) is at least sectionally formed on the upper side (5), wherein
the feed line (3) has at least one feed line contact surface (9),
wherein the feed line contact surface (9) is at least sectionally connected with the sensor contact surface (8) by means of a first sintered layer (10),
**characterized in that**
the first sintered layer (10) consists of a first pre-applied sintered paste layer (13), which is applied to the feed line contact surface (9) and/or the sensor contact surface (8).

2. The temperature sensor assembly (1) according to claim 1, **characterized in that** the feed line (3) is flexible in design.

3. The temperature sensor assembly (1) according to any one of claims 1 or 2,
**characterized in that**
the feed line (3) consists of a metal band and/or a metal wire with at least one flattened end and/or a metal-coated polymer substrate and/or an in particular stamped or lasered or etched metal sheet.

4. The temperature sensor assembly (1) according to one of the preceding claims,
**characterized in that**
the temperature sensor structure (7) is designed as a resistance element.

5. The temperature sensor assembly (1) according to one of the preceding claims,
**characterized in that**
the temperature sensor structure (7) and/or the sensor contact surface (8) has platinum material.

6. The temperature sensor assembly (1) according to one of the preceding claims,
**characterized by**
at least one passivation layer, which is formed at least sectionally on the temperature sensor structure (7) and/or, preferably entirely, on the upper side (5) of the substrate (4).

7. The temperature sensor assembly (1) according to claim 6,
**characterized in that**
the passivation layer has a polyimide material and/or a glass material and/or a ceramic material and/or a glass ceramic material.

8. The temperature sensor assembly (1) according to one of the preceding claims,
**characterized in that**
the substrate (4) has a ceramic insulating material, in particular aluminum oxide and/or aluminum nitride and/or silicon nitride and/or a glass sandwich material.

9. The temperature sensor assembly (1) according to one of the preceding claims,
**characterized in that**
a metallization layer (11) is formed on the lower side (6) of the substrate (4), and preferably has a silver material and/or a gold material and/or a metal alloy.

10. The temperature sensor assembly (1) according to one of the preceding claims, particularly according to claim 9,
**characterized in that**
a second sintered layer and/or a second sintered paste layer (12) is formed on the lower side (6) of the substrate (4) or on the metallization layer (11).

11. The temperature sensor assembly (1) according to claim 10,
**characterized in that**
the second sintered layer consists of a second pre-applied sintered paste layer (12).

12. The temperature sensor assembly (1) according to one of the preceding claims,
**characterized in that**
the first sintered layer (10) and/or the second sintered layer and/or the first pre-applied sintered paste layer (13) and/or the second pre-applied sintered paste layer (12) has/have metal particles, in particular precious metal particles, especially preferably silver particles and/or gold particles and/or platinum particles.

13. A method for manufacturing a temperature sensor assembly (1) according to any one of claims 1 to 12, comprising at least one temperature sensor (2) and at least one feed line (3),
**characterized by** the following method steps:
- Providing a temperature sensor (2) that has at least one electrically insulating substrate (4) with an upper side (5) and a lower side (6), wherein a temperature sensor structure (7) with at least one sensor contact surface (8) is at least sectionally formed on the upper side (5),
- Providing a feed line (3) having at least one feed line contact surface (9),
- Applying a sintered paste to the sensor contact surface (8) and/or the feed line contact surface (9),
- Forming at least a first pre-applied sintered paste layer (13),
- Connecting the feed line (3) with the temperature sensor (2) by forming a sintered layer (10) based on a sintering process.

14. The method according to claim 13,
**characterized by**
- at least sectionally applying a sintered paste to the lower side (6) of the substrate (4) or to a metallization layer (11) of the substrate (4),
- forming a second pre-applied sintered paste layer (12),
- connecting the temperature sensor (2) with another component by means of print sintering with the second pre-applied sintered paste layer (12).

## Revendications

1. Ensemble de capteur de température (1),
comprenant au moins un capteur de température (2) et au moins une ligne d'alimentation (3),
le capteur de température (2) comportant au moins un substrat (4) isolant électrique, pourvu d'une face supérieure (5) et d'une face inférieure (6), sur la face supérieure (5) étant conçue au moins par endroits une structure (7) de capteur de température, pourvue d'au moins une surface de contact (8) de capteur,
la ligne d'alimentation (3) comportant au moins une surface de contact (9) de ligne d'alimentation, la surface de contact (9) de ligne d'alimentation étant assemblée au moins par endroits avec la surface de contact (8) de capteur au moyen d'une première couche frittée (10) et
**caractérisé en ce que**
la première couche frittée (10) est constituée d'une première couche (13) de pâte de frittage pré-appliquée, qui est appliquée sur la surface de contact (9) de ligne d'alimentation et / ou sur la surface de contact (8) de capteur.

2. Ensemble de capteur de température (1) selon la revendication 1, **caractérisé en ce que** la ligne d'alimentation (3) est conçue de forme souple.

3. Ensemble de capteur de température (1) selon l'une quelconque des revendications 1 ou 2,
**caractérisé en ce que**
la ligne d'alimentation (3) est constituée d'une bande métallique et / ou d'un fil métallique pourvu(e) d'au moins une extrémité aplatie et / ou d'un substrat en polymère revêtu de métal et / ou d'une tôle métallique notamment poinçonnée ou marquée au laser ou gravée chimiquement.

4. Ensemble de capteur de température (1) selon l'une quelconque des revendications précédentes,
**caractérisé en ce que**
la structure (7) de capteur de température est conçue sous la forme d'un élément à résistance.

5. Ensemble de capteur de température (1) selon l'une quelconque des revendications précédentes,
**caractérisé en ce que**
la structure (7) de capteur de température et / ou la surface de contact (8) de capteur comporte un matériau platineux.

6. Ensemble de capteur de température (1) selon l'une quelconque des revendications précédentes,
**caractérisé par**
au moins une couche de passivation, qui est conçue au moins par endroits sur la structure (7) de capteur de température et / ou de préférence à pleine surface sur la face supérieure (5) du substrat (4).

7. Ensemble de capteur de température (1) selon la revendication 6,
**caractérisé en ce que**
la couche de passivation comporte un matériau en polyimide et / ou un matériau en verre et / ou un matériau céramique et / ou un matériau vitrocéramique.

8. Ensemble de capteur de température (1) selon l'une quelconque des revendications précédentes,
**caractérisé en ce que**
le substrat (4) comporte un matériau isolant céramique, notamment un oxyde d'aluminium et / ou un nitrure d'aluminium et / ou un nitrure de silicium et / ou un matériau en verre sandwich.

9. Ensemble de capteur de température (1) selon l'une quelconque des revendications précédentes,
**caractérisé en ce que**
sur la face inférieure (6) du substrat est conçue une couche de métallisation (11) qui comporte de préférence un matériau à base d'argent et / ou un matériau à base d'or et / ou un alliage métallique.

10. Ensemble de capteur de température (1) selon l'une quelconque des revendications précédentes, notamment selon la revendication 9,
**caractérisé en ce que**
sur la face inférieure (6) du substrat (4) ou sur la couche de métallisation (11) est formée une deuxième couche frittée et / ou une deuxième couche (12) de pâte de frittage.

11. Ensemble de capteur de température (1) selon la revendication 10,
**caractérisé en ce que**
la deuxième couche frittée est formée d'une deuxième couche (12) de pâte de frittage pré-appliquée.

12. Ensemble de capteur de température (1) selon l'une quelconque des revendications précédentes,
**caractérisé en ce que**
la première couche frittée (10) et / ou la deuxième couche frittée et / ou la première couche (13) de pâte de frittage pré-appliquée et / ou la deuxième couche (12) de pâte de frittage pré-appliquée comporte / comportent des particules métalliques, notamment des particules de métal précieux, de manière particulièrement préférentielle, des particules d'argent et / ou des particules d'or et / ou de particules de platine.

13. Procédé, destiné à fabriquer un ensemble de capteur de température (1) selon l'une quelconque des revendications 1 à 12, comprenant au moins un capteur de température (2) et au moins une ligne d'alimentation (3),
**caractérisé par** les étapes de procédé consistant à
- mettre à disposition un capteur de température (2) qui comporte au moins un substrat (4) isolant électrique, pourvu d'une face supérieure (5) et d'une face inférieure (6), sur la face supérieure (5) étant conçue au moins par endroits une structure (7) de capteur de température, pourvue d'au moins une surface de contact (8) de capteur,
- mettre à disposition une ligne d'alimentation (3) qui comporte au moins une surface de contact (9) de ligne d'alimentation,
- appliquer une pâte de frittage sur la surface de contact (8) du capteur et / ou sur la surface de contact (9) de la ligne d'alimentation,
- constituer au moins une couche (13) de pâte de frittage pré-appliquée,
- assembler la ligne d'alimentation (3) avec le capteur de température (2) au moyen de la constitution d'une couche de frittage (10) grâce à un processus de frittage.

14. Procédé selon la revendication 13,
**caractérisé par**
- l'application au moins par endroits d'une pâte de frittage sur la face inférieure (6) du substrat ou sur une couche (11) de métallisation du substrat (4),
- la constitution d'une deuxième couche (12) de pâte de frittage pré-appliquée,
- l'assemblage du capteur de température (2) avec un autre composant, au moyen de frittage sous pression, avec la deuxième couche (12) de pâte de frittage pré-appliquée.
